(19) Europäisches Patentamt
European Patent Office
Office européen des brevets

(11) **EP 4 708 362 A1**

(12) **EUROPEAN PATENT APPLICATION**
published in accordance with Art. 153(4) EPC

(43) Date of publication:
**11.03.2026 Bulletin 2026/11**

(21) Application number: **23941507.8**

(22) Date of filing: **13.06.2023**

(51) International Patent Classification (IPC):
**H01L 27/04** (2006.01)    **H01L 21/822** (2006.01)

(86) International application number:
**PCT/JP2023/021817**

(87) International publication number:
**WO 2024/257198 (19.12.2024 Gazette 2024/51)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Mitsubishi Electric Corporation
Tokyo 100-8310 (JP)**

(72) Inventor: **SOMADA, Ichiro
Tokyo 100-8310 (JP)**

(74) Representative: **Pfenning, Meinig & Partner mbB
Patent- und Rechtsanwälte
An der Frauenkirche 20
01067 Dresden (DE)**

(54) **SEMICONDUCTOR DEVICE**

(57)     A semiconductor device includes: a semiconductor substrate (1); a first oxide film (2) formed on a surface of the semiconductor substrate (1); a first oxide film (3) formed on a surface of the first oxide film (2); a passive element (10) formed inside the first oxide film (3); and embedded semiconductors (21) to (23) embedded in a surface of the first oxide film (2) directly below the passive element (10) and including low-concentration impurity regions (21a) to (23a) in which an interface is formed with a back surface of the first oxide film (3), and high-concentration impurity regions (21b) to (23b) bonded to bottom surfaces of the low-concentration impurity regions (21a) to (23a) and having contact surfaces which are exposed to a surface of the first oxide film (3) and to which a voltage is applied, respectively.

## FIG. 1

**Description**

TECHNICAL FIELD

The present disclosure relates to a semiconductor device.

BACKGROUND ART

In a semiconductor device applied to an analog circuit and a high-frequency circuit (RF circuit), contents of suppressing performance deterioration of a passive element at a high frequency in a high frequency region such as several tens of GHz are disclosed in Patent Literature 1.
In the semiconductor device disclosed in Patent Literature 1, a high-resistance Si substrate including an n-type layer and a p-type layer is divided into a CMOS region and a passive element region, an interlayer insulating film is formed on the p-type layer, a wiring layer as an inductor or a transmission line is formed in the interlayer insulating film in the passive element region, and the p-type layer located below the wiring layer does not have a well therein in order to maintain high resistance thereof.

CITATION LIST

PATENT LITERATURE

Patent Literature 1: JP 2011-34992 A

SUMMARY OF INVENTION

TECHNICAL PROBLEM

In recent years, as a semiconductor device, a silicon (Si) -based semiconductor process technique advanced in pattern miniaturization for logic circuits, using silicon (Si), silicon germanium (SiGe) or the like, is progressively being extended to analog circuits, a maximum oscillation frequency of a transistor miniaturized in this process reaches 500 GHz, and application of the silicon-based process to a 300 GHz band scheduled to be utilized in a post 5G generation has attracted attention.
In such a semiconductor device applied to a frequency band exceeding 100 GHz, there is a general idea that a correction circuit that adjusts an impedance is added to a passive element that transmits a signal for correction of manufacturing variations.
However, when the correction circuit is added to the passive element, there arises a problem that the correction circuit affects an analog circuit.
The present disclosure has been made in view of the above points, and an object of the present disclosure is to obtain a semiconductor device suitable for being operated in a frequency band of several tens of GHz, particularly more than 100 GHz by focusing on a semiconductor device operated in a frequency band of several tens of GHz, particularly more than 100 GHz, and applied to, for example, an analog circuit or a high-frequency circuit.

SOLUTION TO PROBLEM

A semiconductor device according to the present disclosure includes: a semiconductor substrate; a first oxide film formed on a surface of the semiconductor substrate; a second oxide film formed on a surface of the first oxide film; a passive element formed inside the second oxide film; and an embedded semiconductor embedded in a surface of the first oxide film directly below the passive element and including a low-concentration impurity region in which an interface is formed with a back surface of the second oxide film, and a high-concentration impurity region bonded to a bottom surface of the low-concentration impurity region and having a contact surface which is exposed to a surface of the second oxide film and to which a voltage is applied.

ADVANTAGEOUS EFFECTS OF INVENTION

According to the present disclosure, it is possible to obtain a semiconductor device suitable for being operated in a frequency band of several tens of GHz, particularly more than 100 GHz.

BRIEF DESCRIPTION OF DRAWINGS

FIG. 1 is a cross-sectional view illustrating a main part of a semiconductor device according to a first embodiment.
FIG. 2 is a perspective projection view illustrating a main part of the semiconductor device according to the first embodiment.
FIG. 3 is a schematic diagram in a case where a voltage higher than a voltage in a passive element is applied to a high-concentration impurity region of a first embedded semiconductor in the semiconductor device according to the first embodiment.
FIG. 4 is a schematic diagram in a case where a voltage lower than a voltage in a passive element is applied to the high-concentration impurity region of the first embedded semiconductor in the semiconductor device according to the first embodiment.
FIG. 5 is a cross-sectional view illustrating a main part of a semiconductor device according to a second embodiment.
FIG. 6 is a perspective projection view illustrating a main part of the semiconductor device according to the second embodiment.
FIG. 7 is a cross-sectional view illustrating an interdigital capacitor which is a main part of a semiconductor device according to a third embodiment.
FIG. 8 is an equivalent circuit diagram of the interdigital capacitor which is the main part of the semiconductor device according to the third embodiment.
FIG. 9 is a diagram illustrating a relationship between an inductive self-resonant frequency and an inductance in the interdigital capacitor which is the main part of the semiconductor device according to the third embodiment.
FIG. 10 is a circuit diagram of a cross-coupled LC resonator load-type oscillation circuit according to a fourth embodiment.

DESCRIPTION OF EMBODIMENTS

First Embodiment.

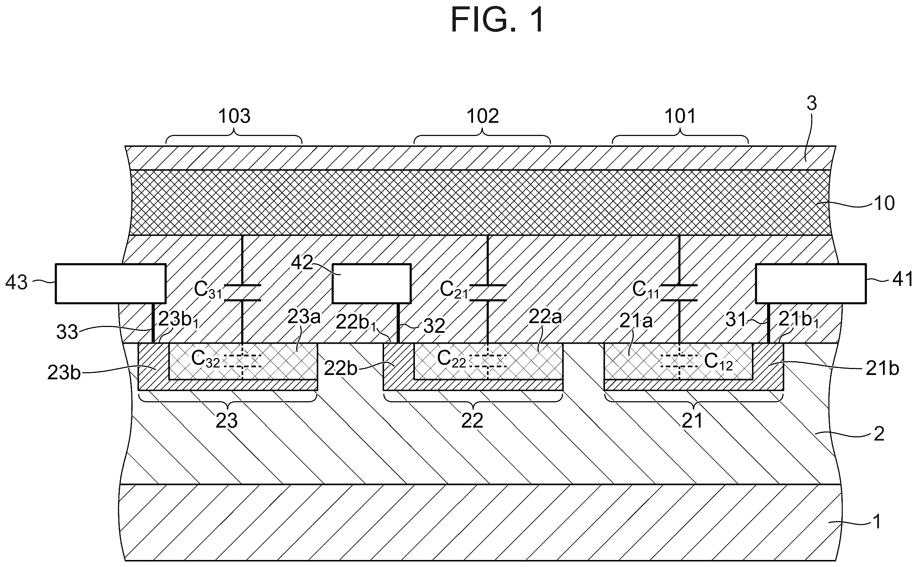

A semiconductor device according to a first embodiment will be described with reference to FIGS. 1 to 4.
The semiconductor device according to the first embodiment is a semiconductor device manufactured by a silicon-based semiconductor process technique applied to an analog circuit or a high-frequency circuit.
The semiconductor device according to the first embodiment is applied to a semiconductor device in which an active circuit such as an amplifier circuit or an oscillator operated in a frequency band of several tens of GHz, particularly more than 100 GHz is formed.
The semiconductor device according to the first embodiment is a semiconductor device that provides a function capable of correcting manufacturing variations with an extremely small influence to a passive element that transmits a signal particularly in a frequency band of more than 100 GHz.
When an active circuit such as an amplifier circuit or an oscillator is designed, an influence of manufacturing variations of a passive element such as a transmission line, a resistor, a capacitor, or an inductor, the influence being not so problematic in a circuit of several tens of GHz or less in which a signal gain of several tens of dB is obtained, that is, an influence of fluctuation in a parasitic capacitance between the passive element and a semiconductor substrate due to a change in film thickness of an oxide film between the passive element and the semiconductor substrate depending on a location due to manufacturing variations within a manufacturing tolerance range, is extremely large because a signal gain obtained in a frequency band of more than 100 GHz is as small as several dB.
The semiconductor device according to the first embodiment is a semiconductor device capable of suppressing deterioration of high-frequency characteristics due to manufacturing variations in a passive element.

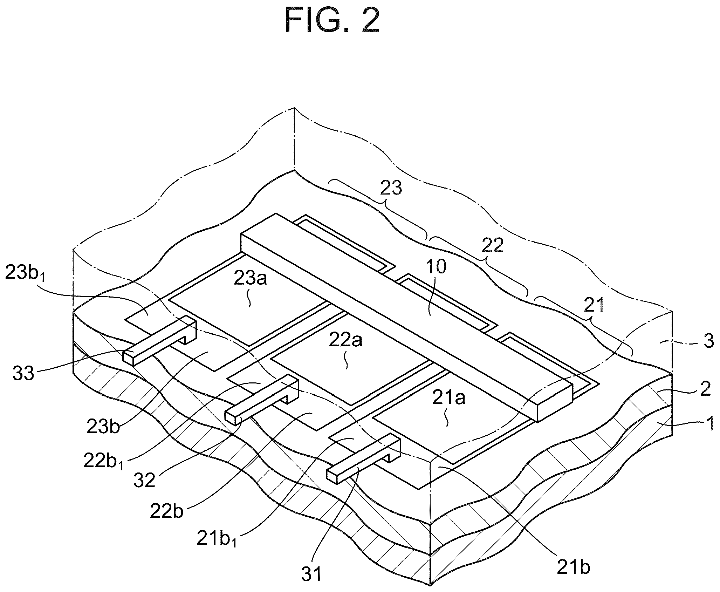

FIG. 1 is a cross-sectional view illustrating a feature point of the semiconductor device according to the first embodiment, and FIG. 2 is a perspective projection view.
In addition, although FIGS. 1 and 2 illustrate one passive element in order to describe the feature point, as the semiconductor device, the number of passive elements is not limited to one, a plurality of passive elements is formed, and a plurality of active elements such as MOS transistors is also formed.
Also in each of a plurality of passive elements in which a high-frequency signal is handled, a feature point is attached to each of the passive elements as illustrated in FIGS. 1 and 2.
As illustrated in FIGS. 1 and 2, the semiconductor device according to the first embodiment includes a semiconductor substrate 1, a first oxide film 2, a second oxide film 3, a passive element 10, a first embedded semiconductor 21 to a third embedded semiconductor 23, and a first control voltage line 31 to a third control voltage line 33.

A ground layer is formed on a back surface of the semiconductor substrate 1 and set to a ground potential.

The passive element 10 is a transmission line, a resistor, a capacitor, an inductor, or the like.

There is no difference in a feature point that suppresses deterioration of high-frequency characteristics among the transmission line, the resistor, the capacitor, and the inductor in the first embodiment. Therefore, in order to avoid complexity of description, the transmission line will be taken as an example of the passive element 10, and will be described as a transmission line 10.

The first oxide film 2 is formed on a surface of the semiconductor substrate 1.

The first oxide film 2 is a silicon oxide film ($SiO_2$) in the first embodiment.

In a surface of the first oxide film 2, embedded regions in which the first embedded semiconductor 21 to the third embedded semiconductor 23 are respectively embedded are formed directly below the transmission line 10 in such a manner as to be separated from each other by grinding the surface by etching or the like.

Although not illustrated, a MOS transistor or the like is formed in another region of the surface of the first oxide film 2.

The second oxide film 3 is formed on the surface of the first oxide film 2 and on surfaces of the first embedded semiconductor 21 to the third embedded semiconductor 23.

The second oxide film 3 is a silicon oxide film deposited on the surface of the first oxide film 2 and the surfaces of the first embedded semiconductor 21 to the third embedded semiconductor 23.

The second oxide film 3 has a plurality of wiring layers therein.

In the second oxide film 3, a silicon oxide film that is located below the transmission line 10, is in contact with a lower surface of the transmission line 10, and forms an interface with the surface of the first oxide film 2 and the surfaces of the first embedded semiconductor 21 to the third embedded semiconductor 23 will be hereinafter referred to as a lowermost oxide film in the second oxide film 3.

A design value of the film thickness of the lowermost oxide film in the second oxide film 3 is, for example, 200 nm in the first embodiment. That is, a distance between the lower surface of the transmission line 10 and each of the surfaces of the first embedded semiconductor 21 to the third embedded semiconductor 23 is set to 200 nm.

The transmission line 10 is a line formed in a lowermost wiring layer among a plurality of wiring layers arranged inside the second oxide film 3, and is a line formed of a metal layer in the first embodiment.

In the first embodiment, the transmission line 10 is, for example, a line having a width of 5 $\mu$m.

In the first embodiment, the transmission line 10 constituting a passive element is, for example, a signal line that transmits a high-frequency signal in a frequency band of more than 100 GHz in an analog circuit, a high-frequency circuit, or an active circuit such as an amplifier circuit or an oscillator.

The first embedded semiconductor 21 to the third embedded semiconductor 23 are embedded in a surface of the first oxide film 2 directly below the transmission line 10 while being separated from each other.

The first embedded semiconductor 21 to the third embedded semiconductor 23 are embedded in corresponding embedded regions formed in the surface of the first oxide film 2 in such a manner as to be separated from each other, respectively.

The surface of each of the first embedded semiconductor 21 to the third embedded semiconductor 23 is located on the same plane as the surface of the first oxide film 2, and is a flat surface together with the surface of the first oxide film 2 by the first embedded semiconductor 21 to the third embedded semiconductor 23 being embedded in corresponding embedded regions formed in the surface of the first oxide film 2, respectively.

In addition, the first embedded semiconductor 21 to the third embedded semiconductor 23 are electrically insulated from each other by the first oxide film 2 and are electrically independent of each other.

The thickness of each of the first embedded semiconductor 21 to the third embedded semiconductor 23 is, for example, 80 nm in the first embodiment.

The first embedded semiconductor 21 to the third embedded semiconductor 23 include low-concentration impurity regions 21a to 23a in which an interface is formed with a bottom surface of the second oxide film 3, and high-concentration impurity regions 21b to 23b having contact surfaces 21b1 to 23b1 which are bonded to bottom surfaces of the low-concentration impurity regions 21a to 23a and exposed to the surface of the second oxide film 3, and to which a voltage is applied, respectively.

Each of the first embedded semiconductor 21 to the third embedded semiconductor 23 is formed as follows in the first embodiment.

First, an intrinsic semiconductor is embedded in a corresponding embedded region formed in a surface of the first oxide film 2. By implanting an n-type impurity from a surface of the intrinsic semiconductor by ion implantation or the like, a low-concentration n-type semiconductor is formed. By ion-implanting an n-type impurity from a surface to a bottom of the low-concentration n-type semiconductor, a virtual electrode region, which is a high-concentration impurity region, is formed at the bottom. Thereafter, in order to form the contact surfaces 21b1 to 23b1 to which a voltage is applied, a region set as each of the contact surface 21b1 to 23b 1, for example, a contact region which is a high-concentration impurity region reaching the virtual electrode region formed at the bottom by ion implantation from the surface of the low-concentration n-type semiconductor to one end portion of the virtual electrode region is formed.

The virtual electrode region and the contact region serve as each of the high-concentration impurity regions 21b to 23b, and the remaining region serves as each of the low-concentration impurity regions 21a to 23a.

Note that the respective low-concentration impurity regions 21a to 23a and high-concentration impurity regions 21b to 23b in the first embedded semiconductor 21 to the third embedded semiconductor 23 are n-type impurity regions, but may be p-type impurity regions.

In addition, the low-concentration impurity regions 21a to 23a and the high-concentration impurity regions 21b to 23b of any of the first embedded semiconductor 21 to the third embedded semiconductor 23 may be n-type impurity regions, and the low-concentration impurity regions 21a to 23a and the high-concentration impurity regions 21b to 23b of the other embedded semiconductor 21 to 23 may be p-type impurity regions.

Furthermore, a combination of an N-type impurity region and a P-type impurity region may be used as long as a depletion layer or a charge accumulation region can be formed at an interface between a bottom surface of the second oxide film 3 and a surface of each of the first embedded semiconductor 21 to the third embedded semiconductor 23 by an applied voltage in the first embedded semiconductor 21 to the third embedded semiconductor 23 when a voltage is applied to the high-concentration impurity regions 21b to 23b.

The first to third control voltage lines 31 to 33 are formed in a wiring layer disposed inside the second oxide film 3, have first ends in ohmic contact with the contact surfaces 21b1 to 23b1 of the high-concentration impurity regions 21b to 23b in the corresponding first to third embedded semiconductors 21 to 23, and have second ends to which control voltages derived from the corresponding first to third control voltage sources 41 to 43 are applied, respectively.

In a first region 101 of the transmission line 10 directly above the first embedded semiconductor 21, there is a parasitic capacitance $C_{11}$ between the first region 101 of the transmission line 10 and the first embedded semiconductor 21.

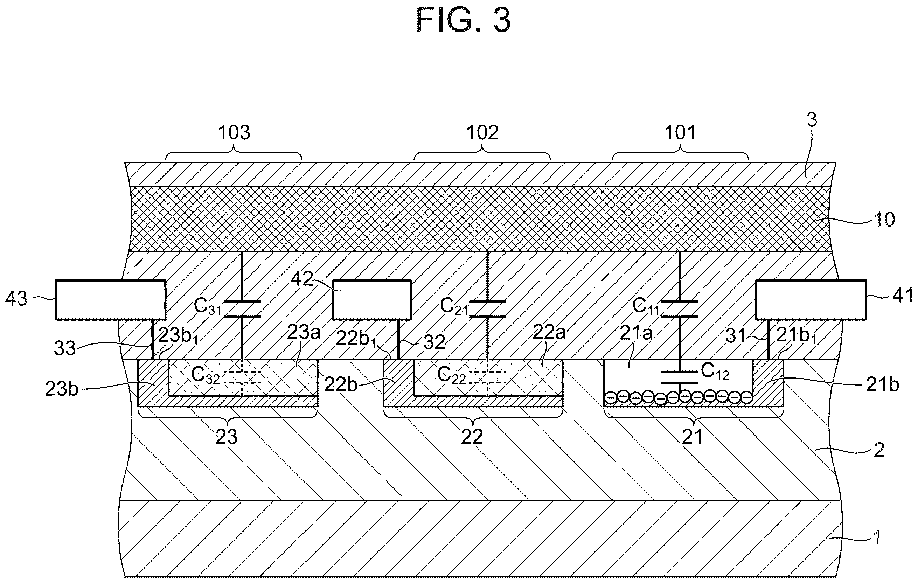

In addition, when a voltage higher than a voltage in the first region 101 of the transmission line 10 is applied to the high-concentration impurity region 21b, as illustrated in FIG. 3, due to a voltage difference between the first region 101 and the high-concentration impurity region 21b, electrons in the low-concentration impurity region 21a are moved away from an interface between a bottom surface of the second oxide film 3 and a surface of the first embedded semiconductor 21, and a depletion layer is generated in the low-concentration impurity region 21a.

As a result, a parasitic capacitance $C_{12}$ is generated between the interface between the bottom surface of the second oxide film 3 and the surface of the first embedded semiconductor 21 and the virtual electrode region of the high-concentration impurity region 21b.

Therefore, a combined parasitic capacitance $C_{10}[C_{11} \times C_{12}/(C_{11}+C_{12})]$ in which the parasitic capacitance $C_{11}$ between the first region 101 of the transmission line 10 and the first embedded semiconductor 21 and the parasitic capacitance $C_{12}$ between the interface between the bottom surface of the second oxide film 3 and the surface of the first embedded semiconductor 21 and the virtual electrode region of the high-concentration impurity region 21b are connected in series is connected to the first region 101 of the transmission line 10.

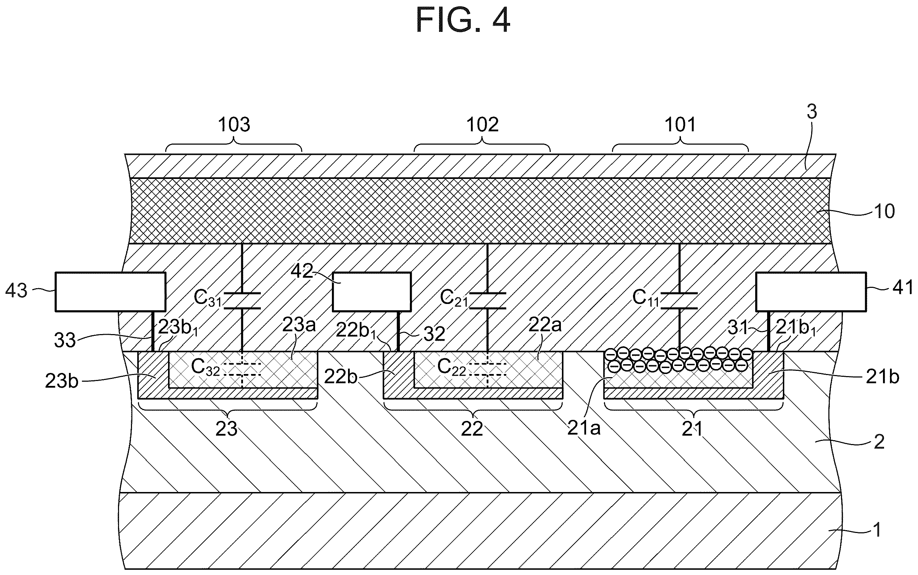

Meanwhile, when a voltage lower than the voltage in the first region 101 of the transmission line 10 is applied to the high-concentration impurity region 21b, as illustrated in FIG. 4, due to a voltage difference between the first region 101 and the high-concentration impurity region 21b, electrons in the low-concentration impurity region 21a are attracted to the interface between the bottom surface of the second oxide film 3 and the surface of the first embedded semiconductor 21, and a charge accumulation region is formed at the interface between the bottom surface of the second oxide film 3 and the surface of the first embedded semiconductor 21.

As a result, the parasitic capacitance $C_{12}$ cannot be seen due to the charge accumulation region, that is, the parasitic capacitance $C_{12}$ is short-circuited.

Therefore, only the parasitic capacitance $C_{11}$ between the first region 101 of the transmission line 10 and the first embedded semiconductor 21 is connected to the first region 101 of the transmission line 10, and a capacitance value of the combined parasitic capacitance $C_{10}$ connected to the first region 101 of the transmission line 10 is a capacitance value of the parasitic capacitance $C_{11}$. The capacitance value of the combined parasitic capacitance $C_{10}$ at this time is a maximum.

That is, the capacitance value of the parasitic capacitance $C_{12}$ can be adjusted by a voltage applied to the high-concentration impurity region 21b because spread of the depletion layer differs depending on the voltage applied to the high-concentration impurity region 21b. As a result, the capacitance value of the combined parasitic capacitance $C_{10}$ connected to the first region 101 of the transmission line 10, that is, the combined capacitance value $[C_{11} \times C_{12}/(C_{11}+C_{12})]$ in which the parasitic capacitance $C_{11}$ and the parasitic capacitance $C_{12}$ are connected in series can also be adjusted from a value obtained by substituting a minimum value of the parasitic capacitance $C_{12}$ to the capacitance value of the parasitic capacitance $C_{11}$.

In a second region 102 of the transmission line 10 directly above the second embedded semiconductor 22, there is a parasitic capacitance $C_{21}$ between the second region 102 of the transmission line 10 and the second embedded semiconductor 22.

In addition, when a voltage higher than a voltage in the second region 102 of the transmission line 10 is applied to the high-concentration impurity region 22b, similarly to the relationship between the first region 101 of the transmission line 10 and the first embedded semiconductor 21, a depletion layer is generated in the low-concentration impurity region 22a due to a voltage difference between the second region 102 and the high-concentration impurity region 22b.

As a result, a parasitic capacitance $C_{22}$ is generated between the interface between the bottom surface of the second oxide film 3 and the surface of the second embedded semiconductor 22 and the virtual electrode region of the high-concentration impurity region 22b.

Therefore, a combined parasitic capacitance $C_{20}[C_{21}\times C_{22}/(C_{21}+C_{22})]$ in which the parasitic capacitance $C_{21}$ between the second region 102 of the transmission line 10 and the second embedded semiconductor 22 and the parasitic capacitance $C_{22}$ between the interface between the bottom surface of the second oxide film 3 and the surface of the second embedded semiconductor 22 and the virtual electrode region of the high-concentration impurity region 22b are connected in series is connected to the second region 102 of the transmission line 10.

Meanwhile, when a voltage lower than the voltage in the second region 102 of the transmission line 10 is applied to the high-concentration impurity region 22b, similarly to the relationship between the first region 101 of the transmission line 10 and the first embedded semiconductor 21, due to a voltage difference between the second region 102 and the high-concentration impurity region 22b, a charge accumulation region is formed at the interface between the bottom surface of the second oxide film 3 and the surface of the second embedded semiconductor 22.

As a result, the parasitic capacitance $C_{22}$ cannot be seen due to the charge accumulation region, that is, the parasitic capacitance $C_{22}$ is short-circuited.

Therefore, only the parasitic capacitance $C_{21}$ between the second region 102 of the transmission line 10 and the second embedded semiconductor 22 is connected to the second region 102 of the transmission line 10, and a capacitance value of the combined parasitic capacitance $C_{20}$ connected to the second region 102 of the transmission line 10 is a capacitance value of the parasitic capacitance $C_{21}$. The capacitance value of the combined parasitic capacitance $C_{20}$ at this time is a maximum.

That is, the capacitance value of the parasitic capacitance $C_{22}$ can be adjusted by a voltage applied to the high-concentration impurity region 22b because spread of the depletion layer differs depending on the voltage applied to the high-concentration impurity region 22b. As a result, the capacitance value of the combined parasitic capacitance $C_{20}$ connected to the second region 102 of the transmission line 10, that is, the combined capacitance value $[C_{21}\times C_{22}/(C_{21}+C_{22})]$ in which the parasitic capacitance $C_{21}$ and the parasitic capacitance $C_{22}$ are connected in series can also be adjusted from a value obtained by substituting a minimum value of the parasitic capacitance $C_{22}$ to the capacitance value of the parasitic capacitance $C_{21}$.

In a third region 103 of the transmission line 10 directly above the third embedded semiconductor 23, there is a parasitic capacitance $C_{31}$ between the third region 103 of the transmission line 10 and the third embedded semiconductor 23.

In addition, when a voltage higher than a voltage in the third region 103 of the transmission line 10 is applied to the high-concentration impurity region 23b, similarly to the relationship between the first region 101 of the transmission line 10 and the first embedded semiconductor 21, a depletion layer is generated in the low-concentration impurity region 23a due to a voltage difference between the third region 103 and the high-concentration impurity region 23b.

As a result, a parasitic capacitance $C_{32}$ is generated between the interface between the bottom surface of the second oxide film 3 and the surface of the third embedded semiconductor 23 and the virtual electrode region of the high-concentration impurity region 23b.

Therefore, a combined parasitic capacitance $C_{30}[C_{31}\times C_{32}/(C_{31}+C_{32})]$ in which the parasitic capacitance $C_{31}$ between the third region 103 of the transmission line 10 and the third embedded semiconductor 23 and the parasitic capacitance $C_{32}$ between the interface between the bottom surface of the second oxide film 3 and the surface of the third embedded semiconductor 23 and the virtual electrode region of the high-concentration impurity region 23b are connected in series is connected to the third region 103 of the transmission line 10.

Meanwhile, when a voltage lower than the voltage in the third region 103 of the transmission line 10 is applied to the high-concentration impurity region 23b, similarly to the relationship between the first region 101 of the transmission line 10 and the first embedded semiconductor 21, due to a voltage difference between the third region 103 and the high-concentration impurity region 23b, a charge accumulation region is formed at the interface between the bottom surface of the second oxide film 3 and the surface of the third embedded semiconductor 23.

As a result, the parasitic capacitance $C_{32}$ cannot be seen due to the charge accumulation region, that is, the parasitic capacitance $C_{32}$ is short-circuited.

Therefore, only the parasitic capacitance $C_{31}$ between the third region 103 of the transmission line 10 and the third embedded semiconductor 23 is connected to the third region 103 of the transmission line 10, and a capacitance value of the combined parasitic capacitance $C_{30}$ connected to the third region 103 of the transmission line 10 is a capacitance value of the parasitic capacitance $C_{31}$. The capacitance value of the combined parasitic capacitance $C_{30}$ at this time is a maximum.

That is, the capacitance value of the parasitic capacitance $C_{32}$ can be adjusted by a voltage applied to the high-concentration impurity region 23b because spread of the depletion layer, that is, the width of the depletion layer differs depending on the voltage applied to the high-concentration impurity region 23b. As a result, the capacitance value of the combined parasitic capacitance $C_{30}$ connected to the third region 103 of the transmission line 10, that is, the combined capacitance value $[C_{31} \times C_{32}/(C_{31}+C_{32})]$ in which the parasitic capacitance $C_{31}$ and the parasitic capacitance $C_{32}$ are connected in series can also be adjusted from a value obtained by substituting a minimum value of the parasitic capacitance $C_{32}$ to the capacitance value of the parasitic capacitance $C_{31}$.

Since the first embedded semiconductor 21 to the third embedded semiconductor 23 are electrically insulated from each other by the first oxide film 2 and independent of each other, the respective combined parasitic capacitances $C_{10}$ to $C_{30}$ in the first region 101 to the third region 103 in the transmission line 10 can be adjusted separately from each other and independently of each other.

Next, a method for improving deterioration of high-frequency characteristics due to a change in a characteristic impedance of the transmission line 10, the change being caused in a case where the film thickness of the lowermost oxide film in the second oxide film 3 directly below the transmission line 10 is different from a set value at a specific location due to manufacturing variations, although the film thickness is within a manufacturing tolerance, will be described.

In a case where a signal in a frequency band of more than 100 GHz is transmitted by the transmission line 10, an influence of fluctuation in a parasitic capacitance connected to the transmission line 10 largely affects the high-frequency characteristics due to the change in the characteristic impedance of the transmission line 10.

Therefore, the semiconductor device according to the first embodiment adjusts the characteristic impedance of the transmission line 10 by adjusting the change in the parasitic capacitance in the transmission line 10 due to the change in the film thickness of the lowermost oxide film in the second oxide film 3 directly below the transmission line 10 due to manufacturing variations, thereby improving the deterioration of the high-frequency characteristics due to the change in the film thickness of the lowermost oxide film.

That is, when the film thickness of the lowermost oxide film in the second oxide film 3 is smaller than a set value, the capacitance values of the parasitic capacitances $C_{11}$ to $C_{31}$ are larger than a set value. Therefore, by adjusting the capacitance values of the parasitic capacitances $C_{12}$ to $C_{32}$ in such a manner as to decrease, the combined parasitic capacitances $C_{10}$ to $C_{30}$ are brought close to a set value.

In addition, when the film thickness of the lowermost oxide film in the second oxide film 3 is larger than a set value, the capacitance values of the parasitic capacitances $C_{11}$ to $C_{31}$ are smaller than a set value. Therefore by adjusting the capacitance values of the parasitic capacitances $C_{12}$ to $C_{32}$ in such a manner as to increase, the combined parasitic capacitances $C_{10}$ to $C_{30}$ are brought close to a set value.

Since adjustments in the first region 101 to the third region 103 of the transmission line 10 can be performed separately and independently, and the adjustments are the same, adjustment in the first region 101 will be described below as a representative.

Here, the film thickness of the lowermost oxide film in the second oxide film 3 is set to 200 nm, the thickness of the first embedded semiconductor 21 is set to 80 nm, the width of the transmission line 10 is set to 5 $\mu$m, and the length of the first region 101 of the transmission line 10 is set to 120 $\mu$m.

In addition, silicon is used as the first embedded semiconductor 21, a silicon oxide film is used as the second oxide film 3, a value of 12 is applied as a relative dielectric constant of silicon, and a value of 3.8 is applied as a relative dielectric constant of the silicon oxide film.

Since the semiconductor substrate 1 is grounded and a manufacturing tolerance of film thickness control in the current microfabrication process is $\pm 15\%$, $\pm 15\%$ is assumed as the manufacturing tolerance.

The semiconductor device according to the first embodiment is designed in such a manner that by controlling a voltage applied to the high-concentration impurity region 21b within the manufacturing tolerance of $\pm 15\%$ of the film thickness of the lowermost oxide film in the second oxide film 3 with respect to the set value of 200 nm, that is, within a range of 170 nm to 230 nm, the combined parasitic capacitance $C_{10}$ is brought close to a set capacitance value of the combined parasitic capacitance $C_{10}$ when the film thickness of the lowermost oxide film in the second oxide film 3 is the set value of 200 nm, and the characteristic impedance of the transmission line 10 is brought close to the set impedance.

That is, a difference between the case where the film thickness of the lowermost oxide film in the second oxide film 3 is smaller than the set value and the case where the film thickness is larger than the set value is only a voltage applied to the high-concentration impurity region 21b, and thus an example of the case where the film thickness is smaller than the set value will be described below.

The film thickness of the lowermost oxide film in the second oxide film 3 in the first region 101 of the transmission line 10 is the set value of 200 nm, and for comparison, the parasitic capacitance $C_{12}$ between the interface between the bottom surface of the second oxide film 3 and the surface of the first embedded semiconductor 21 and the virtual electrode region of the high-concentration impurity region 21b is assumed to be 0.

At this time, a capacitance value of the parasitic capacitance $C_{11}$ between the first region 101 of the transmission line 10 and the first embedded semiconductor 21 is 100 fF, and a characteristic impedance of the transmission line 10 is assumed to be 50 $\Omega$.

Here, it is assumed that the film thickness of the lowermost oxide film in the second oxide film 3 in the first region 101 of the transmission line 10 is reduced by - 15%, which is the maximum value for the reduction in the manufacturing tolerance, and is 170 nm.

The capacitance value of the parasitic capacitance $C_{11}$ at this time is 118 fF.

In the transmission line 10, a characteristic impedance Z is expressed by the following Equation (1) using an inductivity L and a capacitance C of the transmission line 10.

$$Z=\sqrt{(L/C)} \qquad\qquad (1)$$

When the capacitance value of the parasitic capacitance $C_{11}$ increases from 100 fF to 118 fF by 18% due to the manufacturing tolerance of -15%, the value in Equation (1) becomes 1.18 times.

Therefore, a characteristic impedance Z1 in the transmission line 10 at the capacitance value 118 fF of the parasitic capacitance $C_{11}$ is 1/1.089 of the characteristic impedance Z at the set value, and the characteristic impedance Z1 is 45.9 Ω while the characteristic impedance Z at the set value is 50 Ω.

That is, when the film thickness of the lowermost oxide film in the second oxide film 3 in the first region 101 is reduced by 15% with respect to the set value, the characteristic impedance Z of the transmission line 10 is changed from 50 Ω to 45.9 Ω, and an influence on the high-frequency characteristics is large in the semiconductor device that operates in a frequency band of several tens of GHz, particularly more than 100 GHz.

In the semiconductor device according to the first embodiment, an output voltage from the first control voltage source 41 is controlled in such a manner as to apply a voltage higher than a voltage in the transmission line 10 to the high-concentration impurity region 21b from the first control voltage source 41 via the first control voltage line 31, and as illustrated in FIG. 3, a depletion layer is generated in the entire low-concentration impurity region 21a.

As a result, a parasitic capacitance $C_{12}$ is generated between the interface between the bottom surface of the second oxide film 3 and the surface of the first embedded semiconductor 21 and the virtual electrode region of the high-concentration impurity region 21b, and a capacitance value of the parasitic capacitance $C_{12}$ at this time is 796 fF.

As a result, a capacitance value of the combined parasitic capacitance $C_{10}$ in which the parasitic capacitance $C_{11}$ (capacitance value 118 fF) and the parasitic capacitance $C_{12}$ (capacitance value 796 fF) are connected in series to the transmission line 10 is 102 fF.

In short, the capacitance value of the parasitic capacitance in a case where the film thickness of the lowermost oxide film in the second oxide film 3 in the first region 101 is reduced by 15% with respect to the set value of 200 nm is increased from 100 fF as the set value to 102 fF, that is, increased only by 2%, and the characteristic impedance of the transmission line 10 is decreased from 50 Ω to 49 Ω, that is, decreased only by 2%.

Therefore, in the semiconductor device that operates in a frequency band of several tens of GHz, particularly more than 100 GHz, it is possible to improve deterioration of high-frequency characteristics due to an influence of manufacturing variations in the film thickness of the lowermost oxide film in the second oxide film 3 directly below the transmission line 10 with respect to the transmission line 10.

As an example, the case where the film thickness of the lowermost oxide film in the second oxide film 3 is reduced by 15% with respect to the set value of 200 nm has been described. However, since spread of the depletion layer generated in the low-concentration impurity region 21a can be adjusted by a voltage applied to the high-concentration impurity region 21b, and as a result, a capacitance value of the parasitic capacitance $C_{12}$ can be adjusted. Therefore, the capacitance value of the parasitic capacitance $C_{12}$ can be finely adjusted with respect to a change in the film thickness of the lowermost oxide film in the second oxide film 3.

Note that, in the semiconductor device according to the first embodiment, ±15% is assumed as the manufacturing tolerance, but in a case where the manufacturing tolerance exceeds ±15%, it is only required to increase the thickness of the first embedded semiconductor 21, and an adjustment range of a capacitance value of the combined parasitic capacitance C10 can be widened by increasing the thickness of the first embedded semiconductor 21.

In short, it is only required to set the thickness of the first embedded semiconductor 21 by the film thickness of the lowermost oxide film in the second oxide film 3 and the manufacturing tolerance, and it is only required to adjust a voltage applied to the high-concentration impurity region 21b from the first control voltage source 41 together.

In addition, also in the second region 102 of the transmission line 10, the second embedded semiconductor 22 is electrically insulated by the first oxide film 2 and is electrically independent. Therefore, similarly to the first region 101 of the transmission line 10, by applying a control voltage from the second control voltage source 42 via the second control voltage line 32 to the high-concentration impurity region 22b of the second embedded semiconductor 22 depending on manufacturing variations of the film thickness of the lowermost oxide film in the second oxide film 3, a capacitance value of the combined parasitic capacitance C20 can be brought close to a set value, and deterioration of a characteristic impedance in the second region 201 of the transmission line 10 can be improved.

In addition, also in the third region 103 of the transmission line 10, the third embedded semiconductor 23 is electrically insulated by the first oxide film 2 and is electrically independent. Therefore, similarly to the first region 101 of the transmission line 10, by applying a control voltage from the third control voltage source 43 via the third control voltage line 33 to the high-concentration impurity region 23b of the third embedded semiconductor 23 depending on manufacturing variations of the film thickness of the lowermost oxide film in the second oxide film 3, a capacitance value of the combined parasitic capacitance C30 can be brought close to a set value, and deterioration of a characteristic impedance in the third region 103 of the transmission line 10 can be improved.

Therefore, even when the film thickness of each of the lowermost oxide films in the second oxide film 3 directly below the first region 101 to the third region 103 of the transmission line 10 changes to a different value within the range of the manufacturing tolerance, by independently controlling voltages applied to the first embedded semiconductor 21 to the third embedded semiconductor 23, capacitance values of the parasitic capacitances with respect to the first region 101 to the third region 103 of the transmission line 10 can be individually adjusted, deterioration of the characteristic impedances in the first region 101 to the third region 103 of the transmission line 10 can be improved, and deterioration of the characteristic impedance can be improved in the entire transmission line 10.

Note that by arranging embedded semiconductors electrically insulated by the first oxide film 2 and electrically independent with respect to a plurality of the transmission lines 10, respectively, it is possible to individually increase or decrease a capacitance value of a combined parasitic capacitance depending on manufacturing variations of the lowermost oxide film in the second oxide film 3 directly below each of the plurality of transmission lines 10, thereby bringing the capacitance value close to a set value, and it is possible to improve deterioration of the characteristic impedance in each of the transmission lines 10.

In addition, the transmission line 10 is divided into three regions of the first region 101 to the third region 103, and the embedded semiconductors are arranged directly below the three regions, respectively. However, depending on the transmission line 10, the transmission line 10 may be divided into one or two regions, and the embedded semiconductors may be arranged directly below the one or two regions, respectively, or the transmission line 10 may be divided into four or more regions, and the embedded semiconductors may be arranged directly below the four or more regions, respectively.

Although the transmission line has been mainly described as the passive element 10, as the passive element 10, a resistance element formed by narrowing a line width of a line in a lowermost wiring layer disposed inside the second oxide film 3, a capacitor in which a pair of lines arranged in parallel in the wiring layer is used as a pair of electrodes, and an inductor formed by bending a line in the wiring layer may be applied to the embedded semiconductor similarly to the transmission line.

In the first embodiment, although the case of one passive element 10 has been mainly described, the parasitic capacitance in the passive element 10 can be individually adjusted for each of a plurality of passive elements by adding a feature point in each of the plurality of passive elements 10 as illustrated in FIGS. 1 and 2.

As described above, the semiconductor device according to the first embodiment includes the embedded semiconductors 21 to 23 embedded in the surface of the first oxide film 2 directly below the passive element 10 formed inside the second oxide film 3 formed on the surface of the first oxide film 2 formed on the surface of the semiconductor substrate 1 and including the low-concentration impurity regions 21a to 23a in which an interface is formed with the back surface of the second oxide film 3, and the high-concentration impurity regions 21b to 23b bonded to the bottom surfaces of the low-concentration impurity regions 21a to 23a and having contact surfaces which are exposed to the surface of the second oxide film 3 and to which a voltage is applied. Therefore, by controlling voltages applied to the high-concentration impurity regions 21b to 23b with respect to a change in parasitic capacitance in the passive element 10 due to a change due to manufacturing variations of the film thickness of the second oxide film 3 directly below the passive element 10, the parasitic capacitance in the passive element 10 can be adjusted, deterioration of the characteristic impedance of the passive element 10 can be improved, and as a result, deterioration of high-frequency characteristics in a frequency band of several tens of GHz, particularly more than 100 GHz can be improved.

The semiconductor device according to the first embodiment can improve deterioration of the characteristic impedance of the passive element 10 by a simple configuration in which an embedded semiconductor is disposed directly below the passive element 10 without requiring a special circuit in order to improve deterioration of the characteristic impedance of the passive element 10.

In addition, in the semiconductor device according to the first embodiment, by arranging the plurality of embedded semiconductors which are separated from each other and electrically independent of each other along the passive element 10 directly below the passive element 10, deterioration of the characteristic impedances in the plurality of regions 101 to 103 of the passive element 10 can be individually improved, and deterioration of the characteristic impedance can be improved in the entire passive element 10.

Furthermore, in the semiconductor device according to the first embodiment, by arranging the embedded semiconductors which are separated from each other and electrically independent of each other along the plurality of passive element 10 directly below the passive elements 10, respectively, the parasitic capacitance in each of the plurality of passive elements 10 can be individually adjusted, and deterioration of the characteristic impedance in each of the passive elements 10 can be individually improved.

Second Embodiment.

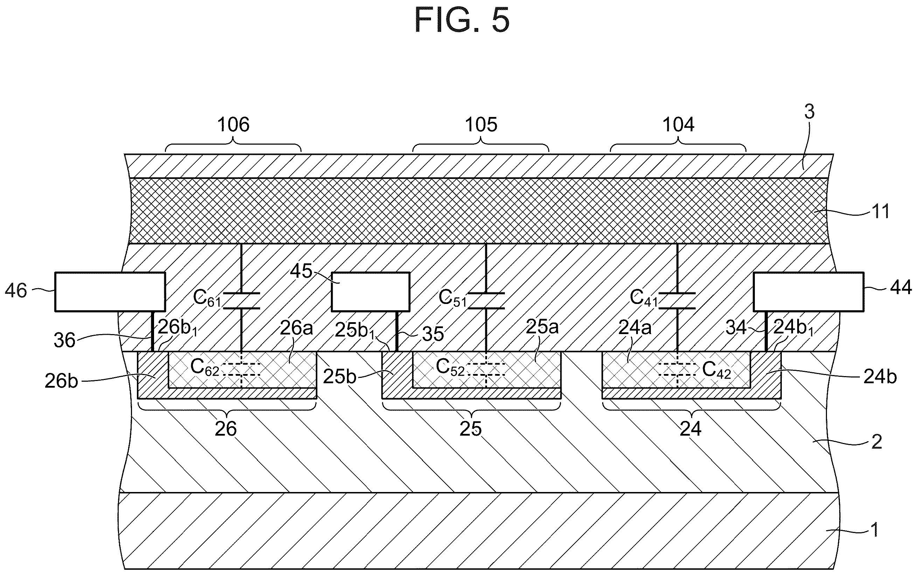

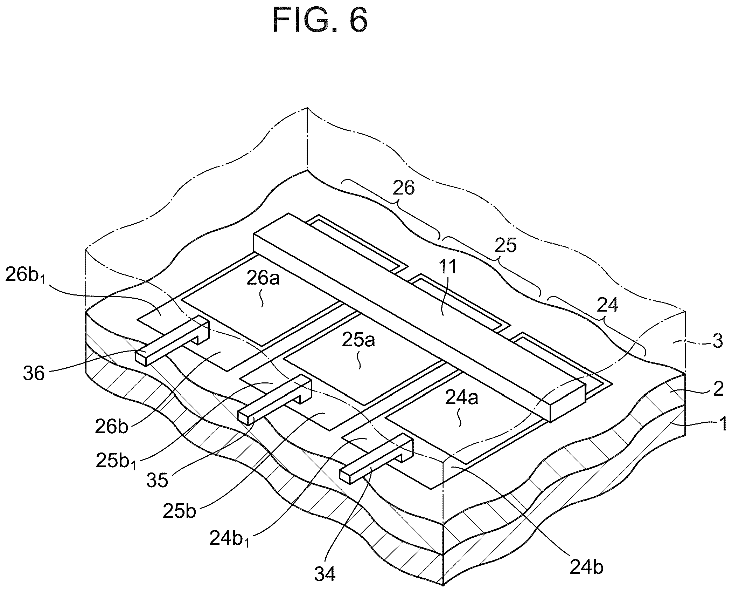

A semiconductor device according to a second embodiment will be described with reference to FIGS. 5 and 6.

The semiconductor device according to the second embodiment is a semiconductor device manufactured by a silicon-based semiconductor process technique applied to an analog circuit or a high-frequency circuit.

The semiconductor device according to the second embodiment is applied to a semiconductor device in which an active circuit such as an amplifier circuit or an oscillator operated in a frequency band of several tens of GHz, particularly more than 100 GHz is formed.

The semiconductor device according to the second embodiment is a semiconductor device including a transmission line suitable for operation in a frequency band of several tens of GHz, particularly more than 100 GHz, and capable of dynamically changing characteristics.

That is, the semiconductor device according to the second embodiment is a semiconductor device that provides a function capable of adjusting an impedance with an extremely small influence to a passive element that transmits a signal particularly in a frequency band of more than 100 GHz.

FIG. 5 is a cross-sectional view illustrating a feature point of the semiconductor device according to the second embodiment, and FIG. 6 is a perspective projection view.

In addition, although FIGS. 5 and 6 illustrate one transmission line in order to describe the feature point, as the semiconductor device, the number of transmission lines is not limited to one, a plurality of transmission lines is formed, and a plurality of active elements such as MOS transistors is also formed.

Also in each of a plurality of transmission lines in which a high-frequency signal is handled, a feature point is attached to each of the transmission lines as illustrated in FIGS. 5 and 6.

As illustrated in FIGS. 5 and 6, the semiconductor device according to the second embodiment includes a semiconductor substrate 1, a first oxide film 2, a second oxide film 3, a transmission line 11, a plurality of embedded semiconductors 24 to 26, and a plurality of control voltage lines 34 to 36.

A ground layer is formed on a back surface of the semiconductor substrate 1 and set to a ground potential.

The transmission line 11 has a plurality of regions 104 to 106. Each of the regions 104 to 106 in the transmission line 11 is not a physically divided region, but is a region in which a region for independently controlling a characteristic impedance of the transmission line 11 is virtually set.

In the second embodiment, three regions 104 to 106 in the transmission line 11 are illustrated, but the number of the regions is not limited to three, and may be four or more. In addition, when the transmission line 11 is branched, a branch destination may be further set as a region.

The first oxide film 2 is formed on a surface of the semiconductor substrate 1. The first oxide film 2 is a silicon oxide film in the second embodiment.

In a surface of the first oxide film 2, embedded regions in which the plurality of embedded semiconductors 24 to 26 are embedded are formed directly below the regions 104 to 106 in the transmission line 11, respectively, in such a manner as to be separated from each other by grinding the surface by etching or the like.

Although not illustrated, a MOS transistor or the like is formed in another region of the surface of the first oxide film 2.

The second oxide film 3 is formed on the surface of the first oxide film 2 and on surfaces of the plurality of embedded semiconductors 24 to 26.

The second oxide film 3 is a silicon oxide film deposited on the surface of the first oxide film 2 and the surfaces of the plurality of embedded semiconductors 24 to 26.

The second oxide film 3 has a plurality of wiring layers therein.

In the second oxide film 3, a silicon oxide film that is located below the transmission line 11, is in contact with a lower surface of the transmission line 11, and forms an interface with the surface of the first oxide film 2 and the surfaces of the plurality of embedded semiconductors 24 to 26 will be hereinafter referred to as a lowermost oxide film in the second oxide film 3.

A design value of the film thickness of the lowermost oxide film in the second oxide film 3 is, for example, 200 nm in the second embodiment. That is, a distance between the lower surface of the transmission line 11 and each of the surfaces of the plurality of embedded semiconductors 24 to 26 is set to 200 nm.

The transmission line 11 is a line formed in a lowermost wiring layer among a plurality of wiring layers arranged inside the second oxide film 3, and is a line formed of a metal layer in the second embodiment.

In the second embodiment, the transmission line 11 is, for example, a line having a width of 5 μm.

In the second embodiment, the transmission line 11 is, for example, a signal line that transmits a high-frequency signal in a frequency band of more than 100 GHz in an analog circuit, a high-frequency circuit, or an active circuit such as an amplifier circuit or an oscillator.

The plurality of embedded semiconductors 24 to 26 correspond to the plurality of regions 104 to 106 of the transmission line 11, and are embedded in embedded regions formed in the surface of the first oxide film 2 directly below the plurality of regions 104 to 106 of the transmission line 11 corresponding to the plurality of regions 104 to 106, respectively.

The plurality of embedded semiconductors 24 to 26 are arranged in such a manner as to be separated from each other.

The plurality of embedded semiconductors 24 to 26 include low-concentration impurity regions 24a to 26a in which an interface is formed with the second oxide film 3, and high-concentration impurity regions 24b to 26b having contact surfaces $24b_1$ to $26b_1$ which are bonded to bottom surfaces of the low-concentration impurity regions 24a to 26a and exposed to the surface of the second oxide film 3, and to which voltages are applied independently of each other, respectively.

The high-concentration impurity regions 24b to 26b have virtual electrode regions formed at bottoms and contact regions reaching the virtual electrode regions from the contact surfaces $24b_1$ to $26b_1$ in one end portions of the virtual electrode regions, respectively.

The surface of each of the plurality of embedded semiconductors 24 to 26 is embedded in a corresponding embedded region formed in the surface of the first oxide film 2, is thereby located on the same plane as the surface of the first oxide film 2, and is a flat surface together with the surface of the first oxide film 2.

The plurality of embedded semiconductors 24 to 26 are electrically insulated from each other by the first oxide film 2 and are electrically independent of each other.

The thickness of each of the plurality of embedded semiconductors 24 to 26 is, for example, 80 nm in the second embodiment.

Note that the respective low-concentration impurity regions 24a to 26a and high-concentration impurity regions 24b to 26b in the plurality of embedded semiconductors 24 to 26 are n-type impurity regions, but may be p-type impurity regions.

In addition, the low-concentration impurity regions 24a to 26a and the high-concentration impurity regions 24b to 26b in any of the plurality of embedded semiconductors 24 to 26 may be n-type impurity regions, and the low-concentration impurity regions 24a to 26a and the high-concentration impurity regions 24b to 26b in the other embedded semiconductor 24 to 26 may be p-type impurity regions.

Furthermore, a combination of an N-type impurity region and a P-type impurity region may be used as long as a depletion layer or a charge accumulation region can be formed at an interface between a bottom surface of the second oxide film 3 and a surface of each of the plurality of embedded semiconductors 24 to 26 by an applied voltage in the plurality of embedded semiconductors 24 to 26 when a voltage is applied to the high-concentration impurity regions 24b to 26b.

The plurality of control voltage lines 34 to 36 are formed in a wiring layer disposed inside the second oxide film 3, have first ends in ohmic contact with the contact surfaces $24b_1$ to $26b_1$ of the high-concentration impurity regions 24b to 26b in the corresponding embedded semiconductors 24 to 26, and have second ends to which control voltages derived from the corresponding control voltage sources 44 to 46 are applied, respectively.

In the region 104 of the transmission line 11 directly above the embedded semiconductor 24, there is a capacitance $C_{41}$ between the region 104 of the transmission line 11 and the surface of the embedded semiconductor 24.

In addition, by applying a control voltage derived from the control voltage source 44 via the control voltage line 34 to the high-concentration impurity region 24b from the contact surface $24b_1$, a variable capacitance $C_{42}$ corresponding to spread of a depletion layer generated in the low-concentration impurity region 24a is generated.

A capacitance value of the variable capacitance $C_{42}$ can be adjusted by a voltage applied to the high-concentration impurity region 24b.

Therefore, a variable combined capacitance $C_{40}$ [capacitance value: $C_{41} \times C_{42}/(C_{41}+C_{42})$] in which the variable capacitance $C_{41}$ between the region 104 of the transmission line 11 and the embedded semiconductor 24 and the variable capacitance $C_{42}$ between the interface between the bottom surface of the second oxide film 3 and the surface of the embedded semiconductor 24 and the virtual electrode region of the high-concentration impurity region 24b are connected in series is connected to the region 104 of the transmission line 11.

That is, when the voltage applied to the high-concentration impurity region 24b is higher than the voltage in the region 104 of the transmission line 11, a capacitance value of the variable capacitance $C_{42}$ decreases, a capacitance value of the variable combined capacitance $C_{40}$ decreases, and a characteristic impedance in the region 104 of the transmission line 11 can be increased.

Meanwhile, when the voltage applied to the high-concentration impurity region 24b is lower than the voltage in the region 104 of the transmission line 11, a capacitance value of the variable capacitance $C_{42}$ increases, a capacitance value of the variable combined capacitance $C_{40}$ increases, and the characteristic impedance in the region 104 of the transmission line 11 can be decreased.

As described above, by controlling the voltage applied to the high-concentration impurity region 24b, the characteristic impedance in the region 104 of the transmission line 11 can be dynamically controlled, and high-frequency circuit characteristics can be dynamically changed.

Note that the capacitance value of the variable combined capacitance $C_{40}$ connected to the region 104 of the transmission line 11, that is, a capacitance value $[C_{41}\times C_{42}/(C_{41}+C_{42})]$ of the variable combined capacitance $C_{40}$ in which the capacitance $C_{41}$ and the variable capacitance $C_{42}$ are connected in series can be adjusted from a value obtained by substituting a minimum value of the variable capacitance $C_{42}$ to the capacitance value of the parasitic capacitance $C_{11}$.

In addition, also in the region 105 of the transmission line 11 directly above the embedded semiconductor 25, similarly to the region 104 of the transmission line 11 directly above the embedded semiconductor 24, there is a variable combined capacitance $C_{50}$ [capacitance value: $C_{51}\times C_{52}/(C_{51}+C_{52})$] in which a variable capacitance $C_{51}$ between the region 105 of the transmission line 11 and the surface of the embedded semiconductor 25 and a variable capacitance $C_{52}$ between the interface between the bottom surface of the second oxide film 3 and the surface of the embedded semiconductor 25 and the virtual electrode region of the high-concentration impurity region 25b are connected in series.

Therefore, by controlling the voltage applied to the high-concentration impurity region 25b, the characteristic impedance in the region 105 of the transmission line 11 can be dynamically controlled, and high-frequency circuit characteristics can be dynamically changed.

Furthermore, also in the region 106 of the transmission line 11 directly above the embedded semiconductor 26, similarly to the region 104 of the transmission line 11 directly above the embedded semiconductor 24, there is a variable combined capacitance $C_{60}$ [capacitance value: $C_{61}\times C_{62}/(C_{61}+C_{62})$] in which a variable capacitance $C_{61}$ between the region 106 of the transmission line 11 and the surface of the embedded semiconductor 26 and a variable capacitance $C_{62}$ between the interface between the bottom surface of the second oxide film 3 and the surface of the embedded semiconductor 26 and the virtual electrode region of the high-concentration impurity region 26b are connected in series.

Therefore, by controlling the voltage applied to the high-concentration impurity region 26b, the characteristic impedance in the region 106 of the transmission line 11 can be dynamically controlled, and high-frequency circuit characteristics can be dynamically changed.

Since the plurality of embedded semiconductors 24 to 26 are electrically insulated from each other by the first oxide film 2 and are electrically independent of each other, the voltages applied to the respective high-concentration impurity regions 24b to 26b in the plurality of embedded semiconductors 24 to 26 can also be independently controlled. Therefore, the characteristic impedances in the plurality of regions 104 to 106 of the transmission line 11 can be dynamically controlled.

For example, in the three adjacent regions 104 to 106 of the transmission line 11, by applying a voltage higher than the voltage in the central region 105 of the transmission line 11 to the high-concentration impurity region 25b of the embedded semiconductor 25 corresponding to the central region 105 in the three regions 104 to 106, the characteristic impedance in the region 105 of the transmission line 11 is increased, and by applying a voltage lower than the voltage in the corresponding regions 104 and 106 of the regions 104 and 106 on both sides of the transmission line 11 to the high-concentration impurity regions 24b and 26b of the embedded semiconductors 24 and 26 corresponding to the regions 104 and 106 on both sides, the characteristic impedances in the regions 104 and 106 of the transmission line 11 are decreased.

As described above, by increasing the characteristic impedance in the central region 105 of the transmission line 11 and decreasing the characteristic impedances in the regions 104 and 106 on both sides, characteristic impedance mismatch occurs between the region 105 and the region 104 and between the region 105 and the region 106 of the transmission line 11, reflection is caused with respect to a high-frequency signal passing through the transmission line 11, and the high-frequency signal can be attenuated.

Meanwhile, by controlling the voltages applied to the respective high-concentration impurity regions 24b to 26b in the plurality of embedded semiconductors 24 to 26, the characteristic impedances in the region 104 to 106 of the transmission line 11 are made equal to each other, whereby a high-frequency signal passing through the transmission line 11 passes through the region 104 to 106 of the transmission line 11 without being attenuated.

Note that, in the three adjacent regions 104 to 106 of the transmission line 11, by applying a voltage lower than the voltage in the central region 105 of the transmission line 11 to the high-concentration impurity region 25b of the embedded semiconductor 25 corresponding to the central region 105 in the three regions 104 to 106, the characteristic impedance in the region 105 of the transmission line 11 is decreased, and by applying a voltage higher than the voltage in the corresponding regions 104 and 106 of the regions 104 and 106 on both sides of the transmission line 11 to the high-concentration impurity regions 24b and 26b of the embedded semiconductors 24 and 26 corresponding to the regions 104 and 106 on both sides, the characteristic impedances in the regions 104 and 106 of the transmission line 11 are increased, whereby characteristic impedance mismatch may be caused.

As described above, the semiconductor device according to the second embodiment includes the plurality of embedded semiconductors 24 to 26 corresponding to the plurality of regions of the transmission line 11 formed inside the second oxide film 3 formed on the surface of the first oxide film 2 formed on the surface of the semiconductor substrate 1. The embedded semiconductors 24 to 26 are embedded in the surface of the first oxide film 2 directly below the corresponding regions of the transmission line 11 and include the low-concentration impurity regions 24a to 26a in which an interface is formed with the back surface of the second oxide film 3, and the high-concentration impurity regions 24b to 26b bonded to the bottom surfaces of the low-concentration impurity regions 24a to 26a and having contact surfaces which is exposed to the surface of the second oxide film 3 and to which a voltage is applied. Therefore, by controlling the voltages applied to the high-concentration impurity regions 24b to 26b, the characteristic impedances in the plurality of regions of the transmission line 11 can be dynamically changed independently.

As a result, in the transmission line 11, it is possible to arbitrarily select to attenuate a high-frequency signal passing through the transmission line 10 by causing characteristic impedance mismatch or to cause the high-frequency signal to pass without the high-frequency signal being attenuated by causing characteristic impedance match.

Third Embodiment.

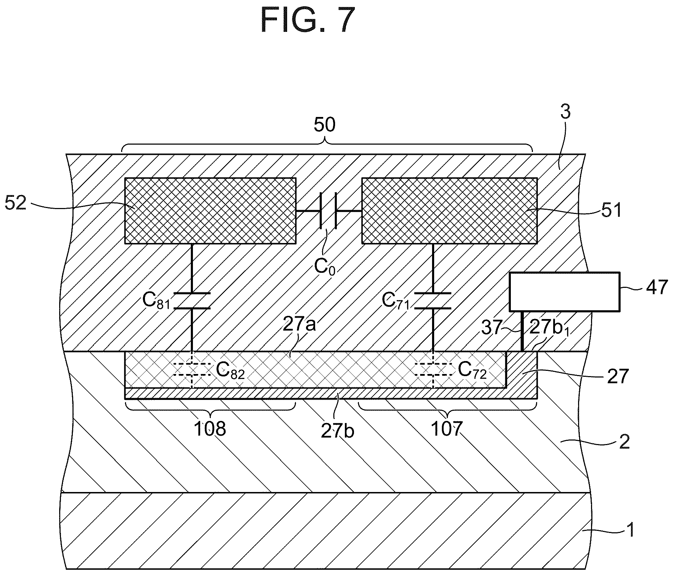

A semiconductor device according to a third embodiment will be described with reference to FIGS. 7 to 9.

The semiconductor device according to the third embodiment is a semiconductor device manufactured by a silicon-based semiconductor process technique applied to an analog circuit or a high-frequency circuit.

The semiconductor device according to the third embodiment is applied to a semiconductor device in which an active circuit such as an amplifier circuit or an oscillator operated in a frequency band of several tens of GHz, particularly more than 100 GHz is formed.

The semiconductor device according to the third embodiment is a semiconductor device that provides a function capable of being used as a variable circuit that actively changes characteristics to a passive element that actively changes characteristics with an extremely small influence to a passive element that transmits a signal particularly in a frequency band of more than 100 GHz.

The semiconductor device according to the third embodiment is a semiconductor device including a variable resonator constituted by an interdigital capacitor suitable for operation in a frequency band of several tens of GHz, particularly more than 100 GHz, furthermore, at a high frequency of terahertz.

FIG. 7 is a cross-sectional view illustrating a feature point of the semiconductor device according to the third embodiment.

In addition, FIG. 7 illustrates a part of a pair of electrodes of the interdigital capacitor in order to explain the feature point. In addition, as the semiconductor device, a plurality of active elements such as MOS transistors is also formed.

As illustrated in FIG. 7, the semiconductor device according to the third embodiment includes a semiconductor substrate 1, a first oxide film 2, a second oxide film 3, an interdigital capacitor 50, an embedded semiconductor 27, and a control voltage line 37.

A ground layer is formed on a back surface of the semiconductor substrate 1 and set to a ground potential.

The interdigital capacitor 50 is a capacitor in which a pair of comb-shaped electrodes 51 and 52 is formed on the same plane. FIG. 7 illustrates a wiring layer constituting an oppositely arranged electrode part in the pair of electrodes 51 and 52 of the interdigital capacitor 50.

The first oxide film 2 is formed on a surface of the semiconductor substrate 1.

The first oxide film 2 is a silicon oxide film in the first embodiment.

In a surface of the first oxide film 2, an embedded region in which the embedded semiconductor 27 is embedded is formed by grinding the surface by etching or the like directly below two lines oppositely arranged in the pair of electrodes 51 and 52 of the interdigital capacitor 50 in such a manner as to straddle the two lines.

Although not illustrated, a MOS transistor or the like is formed in another region of the surface of the first oxide film 2.

The second oxide film 3 is formed on the surface of the first oxide film 2 and on a surface of the embedded semiconductor 27.

The second oxide film 3 is a silicon oxide film deposited on the surface of the first oxide film 2 and the surface of the embedded semiconductor 27.

The second oxide film 3 has a plurality of wiring layers therein.

In the second oxide film 3, a silicon oxide film that is located below the pair of electrodes 51 and 52 of the interdigital capacitor 50, is in contact with a lower surface of the pair of electrodes 51 and 52 of the interdigital capacitor 50, and forms an interface with the surface of the first oxide film 2 and the surface of the embedded semiconductor 27 will be hereinafter referred to as a lowermost oxide film in the second oxide film 3.

A design value of the film thickness of the lowermost oxide film in the second oxide film 3 is, for example, 200 nm in the third embodiment. That is, a distance between the lower surfaces of the pair of electrodes 51 and 52 of the interdigital capacitor 50 and the surface of the embedded semiconductor 27 is set to 200 nm.

The pair of electrodes 51 and 52 of the interdigital capacitor 50 is formed in a lowermost wiring layer among a plurality of wiring layers arranged inside the second oxide film 3, and the wiring layer is formed of a metal layer in the third embodiment.

There is a capacitance $C_0$ between the pair of electrodes 51 and 52.

In order to avoid complication of description, an oppositely arranged electrode part in the pair of electrodes 51 and 52 of the interdigital capacitor 50 illustrated in FIG. 7 will be hereinafter described as the pair of electrodes 51 and 52.

The embedded semiconductor 27 is embedded in the embedded region formed in the surface of the first oxide film 2 in such a manner as to straddle the pair of electrodes 51 and 52 of the interdigital capacitor 50.

That is, the embedded semiconductor 27 is continuously disposed from a region 107 directly below the one electrode 51 to a region 108 directly below the other electrode 52 in such a manner as to be orthogonal to opposing surfaces of the pair of electrodes 51 and 52.

The embedded semiconductor 27 includes a low-concentration impurity regions 27a in which an interface is formed with the second oxide film 3, and a high-concentration impurity region 27b having a contact surface $27b_1$ which is bonded to a bottom surface of the low-concentration impurity region 27a and exposed to the surface of the second oxide film 3, and to which a voltage is applied independently.

The high-concentration impurity region 27b respectively has a virtual electrode region formed at a bottom and a contact region reaching the virtual electrode region from the contact surface $27b_1$ in one end portion of the virtual electrode region.

The surface of the embedded semiconductor 27 is embedded in the embedded region formed in the surface of the first oxide film 2, is thereby located on the same plane as the surface of the first oxide film 2, and is a flat surface together with the surface of the first oxide film 2.

The thickness of the embedded semiconductor 27 is, for example, 80 nm in the second embodiment.

The low-concentration impurity region 27a and the high-concentration impurity region 276b of the embedded semiconductor 27 may be p-type impurity regions.

Furthermore, a combination of an N-type impurity region and a P-type impurity region may be used as long as a depletion layer or a charge accumulation region can be formed at an interface between a bottom surface of the second oxide film 3 and a surface of the embedded semiconductor 27 by an applied voltage in the embedded semiconductor 27 when a voltage is applied to the high-concentration impurity region 27b.

The embedded semiconductor 27 is formed in a wiring layer disposed inside the second oxide film 3, has a first end in ohmic contact with the contact surface $27b_1$ of the high-concentration impurity region 27b in the embedded semiconductor 27, and has a second end to which a control voltage derived from a control voltage source 47 is applied.

There is a first capacitance $C_{71}$ between the one electrode 51 and the surface of the embedded semiconductor 27.

In addition, by applying a control voltage derived from the control voltage source 47 via the control voltage line 37 to the high-concentration impurity region 27b from the contact surface $27b_1$, a first variable capacitance $C_{72}$ corresponding to spread of a depletion layer generated in the low-concentration impurity region 27a is generated between the surface of the embedded semiconductor 27 and the virtual electrode region of the high-concentration impurity region 27b in the region 107 directly below the one electrode 51.

A capacitance value of the first variable capacitance $C_{72}$ can be adjusted by a voltage applied to the high-concentration impurity region 27b.

Therefore, in the one electrode 51, the first capacitance $C_{71}$ between the one electrode 51 and the embedded semiconductor 27 and the first variable capacitance $C_{72}$ between the interface between the bottom surface of the second oxide film 3 and the surface of the embedded semiconductor 27 and the virtual electrode region of the high-concentration impurity region 27b are connected in series.

There is a second capacitance $C_{81}$ between the other electrode 52 and the surface of the embedded semiconductor 27.

In addition, by applying a control voltage derived from the control voltage source 47 via the control voltage line 37 to the high-concentration impurity region 27b from the contact surface $27b_1$, a second variable capacitance $C_{82}$ corresponding to spread of a depletion layer generated in the low-concentration impurity region 24a is generated between the surface of the embedded semiconductor 27 and the virtual electrode region of the high-concentration impurity region 27b in the region 108 directly below the other electrode 51.

A capacitance value of the second variable capacitance $C_{82}$ can be adjusted by a voltage applied to the high-concentration impurity region 27b.

Therefore, in the other electrode 51, the second capacitance $C_{81}$ between the other electrode 51 and the embedded semiconductor 27 and the second variable capacitance $C_{82}$ between the interface between the bottom surface of the second oxide film 3 and the surface of the embedded semiconductor 27 and the virtual electrode region of the high-concentration impurity region 27b are connected in series.

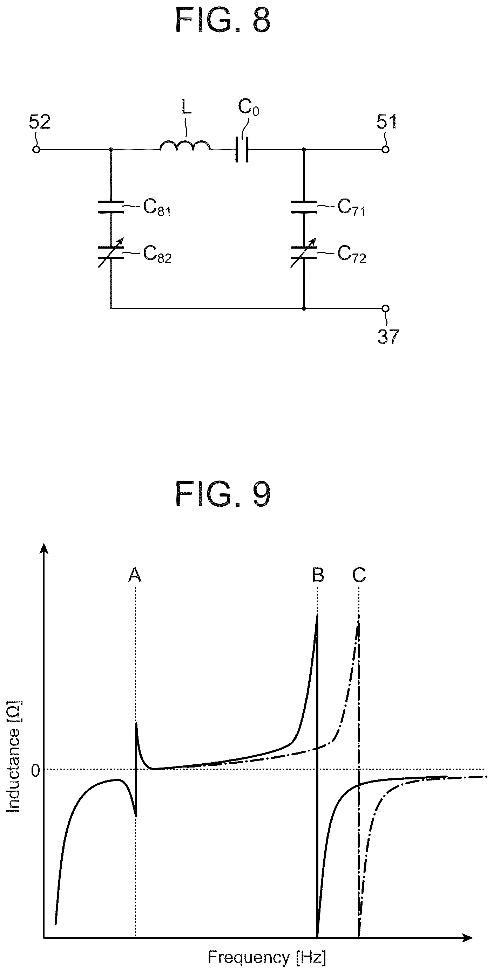

The interdigital capacitor 50, the first capacitance $C_{71}$ and the first variable capacitance $C_{72}$ present in the one electrode 51, and the second capacitance $C_{81}$ and the second variable capacitance $C_{82}$ present in the other electrode 51 constitute an electronic circuit illustrated in FIG. 8.

FIG. 8 is an equivalent circuit diagram, and the electronic circuit illustrated by the equivalent circuit diagram in FIG. 8 is a circuit including the capacitance $C_0$ formed between the pair of electrodes 51 and 52 of the interdigital capacitor 50, an inductance L connected in series to the capacitance $C_0$, the first capacitance $C_{71}$ and the first variable capacitance $C_{72}$ connected in series between the one electrode 51 and the control voltage source 47, and the second capacitance $C_{81}$ and the second variable capacitance $C_{82}$ connected in series between the other electrode 51 and the control voltage source 47.

In the equivalent circuit diagram of FIG. 8, the inductance L connected in series to the capacitance $C_0$ is an inductance parasitic in the pair of comb-shaped electrodes 51 and 52 in the interdigital capacitor 50.

Note that, in the equivalent circuit diagram of FIG. 8, since the inductance L is connected in series to the capacitance $C_0$ between the pair of electrodes 51 and 52 in an equivalent circuit manner, the inductance L is indicated as one inductance L for convenience.

As is apparent from the electronic circuit illustrated in FIG. 8, the electronic circuit illustrated in FIG. 8 constitutes a variable resonator which is an LC resonator having a series-parallel resonant circuit structure.

When the control voltage derived from the control voltage source 47 is controlled and the voltage applied to the high-concentration impurity region 27b via the control voltage line 37 is controlled, a capacitance value of the first variable capacitance $C_{72}$ and a capacitance value of the second capacitance $C_{81}$ change, and therefore a resonance frequency of the variable resonator fluctuates.

An example of the fluctuation of the resonance frequency of the variable resonator illustrated as an equivalent circuit diagram in FIG. 8 will be described with reference to FIG. 9.

In FIG. 9, the horizontal axis represents a frequency, and the vertical axis represents an inductance.

The variable resonator has a capacitive resonance frequency as indicated by a broken line A in FIG. 9.

As indicated by a broken line B in FIG. 9, the variable resonator has an inductive resonance frequency formed by the inductance L, the capacitance $C_0$, and a combined capacitance in which the first capacitance $C_{71}$, the first variable capacitance $C_{72}$, the second capacitance $C_{81}$, and the second variable capacitance $C_{82}$ are connected in series.

When spread of the depletion layer in the low-concentration impurity region 27a in the embedded semiconductor 27 is maximized by applying a voltage higher than the voltage in the pair of electrodes 51 and 52 of the interdigital capacitor 50 to the high-concentration impurity region 27b in the embedded semiconductor 27 by the control voltage derived from the control voltage source 47, a capacitance value of the first variable capacitance $C_{72}$ and a capacitance value of the second variable capacitance $C_{82}$ are minimized, and a capacitance value of the combined capacitance in which the first capacitance $C_{71}$, the first variable capacitance $C_{72}$, the second capacitance $C_{81}$, and the second variable capacitance $C_{82}$ are connected in series is minimized.

At this time, an inductive self-resonant frequency in the variable resonator is maximized, and there is a maximum value of the inductive self-resonant frequency as indicated by a broken line C in FIG. 9.

Meanwhile, when a charge accumulation region is formed at an interface between the surface of the embedded semiconductor 27 and the bottom surface of the second oxide film 3 by applying a voltage lower than the voltage in the pair of electrodes 51 and 52 of the interdigital capacitor 50 to the high-concentration impurity region 27b in the embedded semiconductor 27 by the control voltage derived from the control voltage source 47, the first variable capacitance $C_{72}$ and the second variable capacitance $C_{82}$ are short-circuited, and therefore a capacitance value of the combined capacitance in which the first capacitance $C_{71}$ and the second capacitance $C_{81}$ are connected in series is maximized.

At this time, an inductive self-resonant frequency in the variable resonator is minimized, and there is a minimum value of the inductive self-resonant frequency as indicated by the broken line B in FIG. 9.

Therefore, in the semiconductor device according to the third embodiment, by controlling the voltage applied to the high-concentration impurity region 27b in the embedded semiconductor 27, the resonance frequency of the variable resonator illustrated as an equivalent circuit diagram in FIG. 8 can be changed from a minimum resonance frequency indicated by the broken line B to a maximum resonance frequency indicated by the broken line C as illustrated in FIG. 9.

As described above, the semiconductor device according to the third embodiment includes the embedded semiconductor 27 corresponding to the pair of electrodes 51 and 52 constituting a capacitor formed inside the second oxide film 3 formed on the surface of the first oxide film 2 formed on the surface of the semiconductor substrate 1. The embedded semiconductor 27 is embedded in the surface of the first oxide film 2 directly below the pair of electrodes 51 and 52 and includes the low-concentration impurity region 27a in which an interface is formed with the back surface of the second oxide film 3, and the high-concentration impurity region 27b bonded to the bottom surface of the low-concentration impurity region 27a and having a contact surface which is exposed to the surface of the second oxide film 3 and to which a voltage is applied. Therefore, with a simple configuration in which the embedded semiconductor 27 is disposed directly below the pair of electrodes 51 and 52 constituting the capacitor, it is possible to implement a small variable resonator that operates in a frequency band of several tens of GHz, particularly more than 100 GHz, furthermore, at a high frequency of terahertz.

Fourth embodiment.

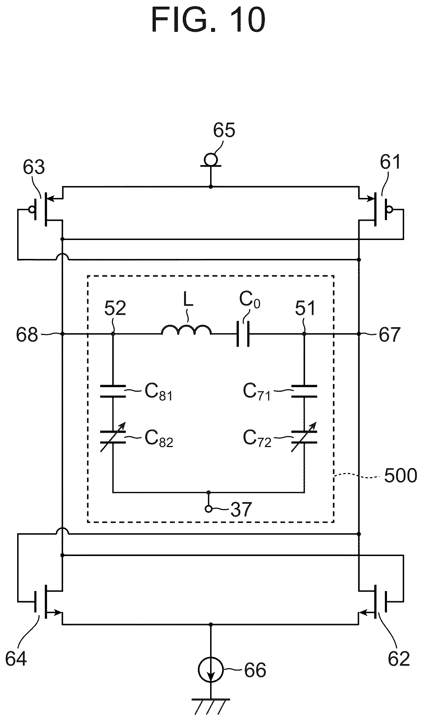

A semiconductor device according to a fourth embodiment will be described with reference to FIG. 10.

The semiconductor device according to the fourth embodiment is a semiconductor device manufactured by a silicon-based semiconductor process technique applied to an analog circuit or a high-frequency circuit.

The semiconductor device according to the fourth embodiment is a semiconductor device incorporating a frequency-variable oscillation circuit operated in a frequency band of several tens of GHz, particularly more than 100 GHz.

The semiconductor device according to the fourth embodiment is a semiconductor device that provides a function capable of being used as a frequency-variable oscillation circuit that actively changes characteristics with an extremely small influence to a passive element that transmits a signal particularly in a frequency band of more than 100 GHz.

The semiconductor device according to the fourth embodiment is a semiconductor device incorporating an oscillation circuit using, as a load, the variable resonator which is an LC resonator in the semiconductor device according to the third embodiment, a so-called cross-coupled LC resonator load oscillation circuit.

As illustrated in a circuit diagram in which a variable resonator as a load is represented by an equivalent circuit in FIG. 10, the semiconductor device according to the fourth embodiment incorporates a cross-coupled LC resonator load oscillation circuit including cross-coupled first MOS transistor 61 to fourth MOS transistor 64, a current source 66, and a variable resonator 500 in the semiconductor device according to the third embodiment.

As described in the third embodiment, the variable resonator 500 includes a semiconductor substrate 1, a first oxide film 2, a second oxide film 3, an interdigital capacitor 50, an embedded semiconductor 27, and a control voltage line 37.

The variable resonator 500 includes a capacitance $C_0$ formed between a pair of electrodes 51 and 52 of the interdigital capacitor 50, an inductance L connected in series to the capacitance $C_0$, a first capacitance $C_{71}$ and a first variable capacitance $C_{72}$ connected in series between the one electrode 51 and a control voltage source 47, and a second capacitance $C_{81}$ and a second variable capacitance $C_{82}$ connected in series between the other electrode 51 and the control voltage source 47.

A resonance frequency of the variable resonator 500 can be changed by a control voltage derived from the control voltage source 47, applied to a high-concentration impurity region 27b in the embedded semiconductor 27 via the control voltage line 37.

In the variable resonator 500, the one electrode 51 of the interdigital capacitor 50 is connected to a first output node 67, and the other electrode 52 of the interdigital capacitor 50 is connected to a second output node 68.

The first MOS transistor 61 to the fourth MOS transistor 64 are formed on a surface of the first oxide film 2.

The first MOS transistor 61 is a P-type transistor connected between the power supply node 65 and the first output node 67, and having a gate electrode connected to the second output node 68.

A source electrode of the first MOS transistor 61 is connected to the power supply node 65, and a drain electrode of the first MOS transistor 61 is connected to the first output node 67.

The second MOS transistor 62 is an N-type transistor connected between the first output node 67 and a current extraction end of the current source 66, and having a gate electrode connected to the second output node 68.

A source electrode of the second MOS transistor 62 is connected to the current extraction end of the current source 66, and a drain electrode of the second MOS transistor 62 is connected to the first output node 67.

The third MOS transistor 63 is a P-type transistor connected between the power supply node 65 and the second output node 68, and having a gate electrode connected to the first output node 67.

A source electrode of the third MOS transistor 63 is connected to the power supply node 65, and a drain electrode of the third MOS transistor 63 is connected to the second output node 68.

The fourth MOS transistor 64 is an N-type transistor connected between the second output node 68 and the current extraction end of the current source 66, and having a gate electrode connected to the first output node 67.

A source electrode of the fourth MOS transistor 64 is connected to the current extraction end of the current source 66, and a drain electrode of the fourth MOS transistor 64 is connected to the second output node 68.

The current source 66 is a constant current source that extracts a current from the cross-coupled first MOS transistor 61 to fourth MOS transistor 64 to the ground node.

The cross-coupled first MOS transistor 61 to fourth MOS transistor 64 have a differential pair configuration by the current source 66.

By controlling a voltage applied to the high-concentration impurity region 27b in the embedded semiconductor 27 constituting the variable resonator 500, a capacitance value of the first variable capacitance $C_{72}$ and a capacitance value of the second variable capacitance $C_{82}$ constituting the variable resonator 500 can be set to a lower side, and therefore the resonance frequency of the variable resonator 500 can be made variable, and as a result, the oscillation frequency of the cross-coupled LC resonator load oscillation circuit can be made variable.

As described above, the semiconductor device according to the fourth embodiment includes, as a load, the variable resonator 500 including the embedded semiconductor 27 corresponding to the pair of electrodes 51 and 52 constituting a capacitor formed inside the second oxide film 3 formed on the surface of the first oxide film 2 formed on the surface of the semiconductor substrate 1, in which the embedded semiconductor 27 is embedded in the surface of the first oxide film 2 directly below the pair of electrodes 51 and 52 and includes the low-concentration impurity region 27a in which an interface is formed with the back surface of the second oxide film 3, and the high-concentration impurity region 27b bonded to the bottom surface of the low-concentration impurity region 27a and having a contact surface which is exposed to the surface of the second oxide film 3 and to which a voltage is applied. Therefore, with a simple configuration in which the embedded semiconductor 27 is disposed directly below the pair of electrodes 51 and 52 constituting the capacitor, it is possible to implement the variable resonator 500 serving as a load, and downsizing can also be achieved as a frequency-variable oscillation circuit that operates in a frequency band of several tens of GHz, particularly more than 100 GHz, and furthermore, at a high frequency of terahertz.

Note that the embodiments can be freely combined to each other, any constituent element in each of the embodiments can be modified, or any constituent element in each of the embodiments can be omitted.

INDUSTRIAL APPLICABILITY

The semiconductor device according to the present disclosure is applied to a semiconductor device manufactured by a silicon-based semiconductor process technique applied to an analog circuit or a high-frequency circuit.

The semiconductor device according to the present disclosure is suitable for a semiconductor device in which an active circuit such as an amplifier circuit or an oscillator operated in a frequency band of several tens of GHz, particularly more than 100 GHz is formed.

REFERENCE SIGNS LIST

1: Semiconductor substrate, 2: First oxide film, 3: Second oxide film, 10: Passive element, 11: Transmission line, 21: First embedded semiconductor, 22: Second embedded semiconductor, 23: Third embedded semiconductor, 24 to 26: Embedded semiconductor, 27: Embedded semiconductor, 31: First control voltage line, 32: Second control voltage line, 33: Third control voltage line, 34 to 36: Control voltage line, 37: Control voltage line, 50: Interdigital capacitor, 51 and 52: Electrode, 61 to 64: First MOS transistor to fourth MOS transistor, 65: Power supply node, 66: Current source

**Claims**

1. A semiconductor device comprising:

   a semiconductor substrate;
   a first oxide film formed on a surface of the semiconductor substrate;
   a second oxide film formed on a surface of the first oxide film;
   a passive element formed inside the second oxide film; and
   an embedded semiconductor embedded in a surface of the first oxide film directly below the passive element and including a low-concentration impurity region, an interface being formed between the low-concentration impurity region and a back surface of the second oxide film, and a high-concentration impurity region bonded to a bottom surface of the low-concentration impurity region, the high-concentration impurity region having a contact surface which is exposed to a surface of the second oxide film and to which a voltage is applied.

2. The semiconductor device according to claim 1, wherein

   the passive element is any one of a transmission line, a resistor, a capacitor, and an inductor disposed in parallel with a surface of the semiconductor substrate, and
   the low-concentration impurity region is a region doped with an N-type impurity at a low concentration, and the high-concentration impurity region is a region doped with an N-type impurity at a high concentration.

3. The semiconductor device according to claim 2, wherein the embedded semiconductor includes a plurality of embedded semiconductors formed in such a manner as to be separated from each other along the passive element.

4. The semiconductor device according to claim 1, wherein the passive element includes a plurality of passive elements, and the embedded semiconductor includes a plurality of embedded semiconductors corresponding to the plurality of passive elements, respectively.

5. A semiconductor device comprising:

   a semiconductor substrate;
   a first oxide film formed on a surface of the semiconductor substrate;
   a second oxide film formed on a surface of the first oxide film;

a transmission line formed inside the second oxide film and having a plurality of regions; and
a plurality of embedded semiconductors that correspond to the plurality of regions of the transmission line, and are embedded in a surface of the first oxide film directly below the corresponding regions of the transmission line, respectively, each of the plurality of embedded semiconductors including a low-concentration impurity region in which an interface is formed with a back surface of the second oxide film, and a high-concentration impurity region bonded to a bottom surface of the low-concentration impurity region and having a contact surface which is exposed to a surface of the second oxide film and to which a voltage is applied independently.

6. The semiconductor device according to claim 5, wherein in three adjacent regions of the plurality of embedded semiconductors, one of a voltage higher and a voltage lower than a voltage in a central region of the transmission line is applied to the high-concentration impurity region of the embedded semiconductors corresponding to the central region in the three regions, and the other of a voltage higher and a voltage lower than a voltage in regions corresponding to regions on both sides of the transmission line is applied to the high-concentration impurity regions of the embedded semiconductors corresponding to the regions on both sides in the three regions.

7. A semiconductor device comprising:

a semiconductor substrate;
a first oxide film formed on a surface of the semiconductor substrate;
a second oxide film formed on a surface of the first oxide film;
a pair of electrodes formed in the same conductive layer inside the second oxide film and constituting a capacitor; and
an embedded semiconductor embedded in a surface of the first oxide film directly below the pair of electrodes and including a low-concentration impurity region in which an interface is formed with a back surface of the second oxide film, and a high-concentration impurity region bonded to a bottom surface of the low-concentration impurity region and having a contact surface which is exposed to a surface of the second oxide film and to which a voltage is applied.

8. The semiconductor device according to claim 7, comprising a variable resonator including:

a capacitance formed between the pair of electrodes of the capacitor and an inductance connected in series to the capacitance;
a first capacitance between one electrode of the pair of electrodes of the capacitor and a surface of the embedded semiconductor, the first capacitance being connected to the one electrode, and a first variable capacitance between the surface of the embedded semiconductor connected in series to the first capacitance and a high-concentration impurity region disposed opposite to the one electrode of the embedded semiconductor; and
a second capacitance between the other electrode of the pair of electrodes of the capacitor and the surface of the embedded semiconductor, the second capacitance being connected to the other electrode, and a second variable capacitance between the surface of the embedded semiconductor connected in series to the second capacitance and a high-concentration impurity region disposed opposite to the other electrode of the embedded semiconductor.

9. The semiconductor device according to claim 7, wherein

the capacitor is an interdigital capacitor, and
the semiconductor device comprises a variable resonator including:

a capacitance formed between the pair of electrodes of the capacitor and an inductance connected in series to the capacitance and parasitic in the pair of electrodes;
a first capacitance between one electrode of the pair of electrodes of the capacitor and a surface of the embedded semiconductor, the first capacitance being connected to the one electrode, and a first variable capacitance between the surface of the embedded semiconductor connected in series to the first capacitance and a high-concentration impurity region disposed opposite to the one electrode of the embedded semiconductor; and
a second capacitance between the other electrode of the pair of electrodes of the capacitor and the surface of the embedded semiconductor, the second capacitance being connected to the other electrode, and a second variable capacitance between the surface of the embedded semiconductor connected in series to the second capacitance and a high-concentration impurity region disposed opposite to the other electrode of the embedded semiconductor.

10. A semiconductor device comprising a frequency-variable oscillation circuit including, as a load, the variable resonator in the semiconductor device according to claim 8 or 9.

11. The semiconductor device according to claim 10, comprising:

a first MOS transistor connected between a power supply node and a first output node, and having a gate electrode connected to a second output node;

a second MOS transistor connected between the first output node and a current extraction end of a current source, and having a gate electrode connected to the second output node; and

a third MOS transistor connected between the power supply node and the second output node, and having a gate electrode connected to the first output node; and

a fourth MOS transistor connected between the second output node and the current extraction end of the current source, and having a gate electrode connected to the first output node, wherein

in the capacitor in the variable resonator, one electrode is connected to the first output node, and the other electrode is connected to the second output node.

# FIG. 1

EP 4 708 362 A1

FIG. 2

# FIG. 3

# FIG. 4

EP 4 708 362 A1

FIG. 5

FIG. 6

FIG. 7

# FIG. 8

# FIG. 9

# FIG. 10

## INTERNATIONAL SEARCH REPORT

International application No.

**PCT/JP2023/021817**

| A. | CLASSIFICATION OF SUBJECT MATTER |
|---|---|

*H01L 27/04*(2006.01)i; *H01L 21/822*(2006.01)i
FI: H01L27/04 V

According to International Patent Classification (IPC) or to both national classification and IPC

| B. | FIELDS SEARCHED |
|---|---|

Minimum documentation searched (classification system followed by classification symbols)

H01L27/04; H01L21/822

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2017-123444 A (DENSO CORP.) 13 July 2017 (2017-07-13) | 1-11 |
| A | JP 2011-34992 A (KABUSHIKI KAISHA TOSHIBA) 17 February 2011 (2011-02-17) | 1-11 |
| A | JP 2000-260939 A (NEC CORP.) 22 September 2000 (2000-09-22) | 1-11 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **08 August 2023** | **22 August 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

29

**INTERNATIONAL SEARCH REPORT**
Information on patent family members

International application No.

**PCT/JP2023/021817**

| Patent document cited in search report | | | Publication date (day/month/year) | Patent family member(s) | | | Publication date (day/month/year) |
|---|---|---|---|---|---|---|---|
| JP | 2017-123444 | A | 13 July 2017 | (Family: none) | | | |
| JP | 2011-34992 | A | 17 February 2011 | US | 2011/0049584 | A1 | |
| JP | 2000-260939 | A | 22 September 2000 | DE | 10012118 | A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011034992 A